# EUROPEAN PATENT APPLICATION

(11) **EP 4 593 079 A1**
(43) Date of publication of application: **30.07.2025**
(21) Application number: 24805093.2
(22) Date of filing: 04.07.2024
(51) Int. Cl.: H01L 23/488

(54) **SEMICONDUCTOR STRUCTURE AND MANUFACTURING METHOD THEREFOR**

(30) Priority: 14.12.2023 CN 202311728460
(71) Applicant: CXMT Corporation, Hefei City, Anhui Province 230601 (CN)
(72) Inventor: WU, Shuangshuang, Hefei Anhui 230601 (CN); WANG, Chunyang, Hefei Anhui 230601 (CN); CHEN, Xiaolong, Hefei Anhui 230601 (CN); XU, Yuting, Hefei Anhui 230601 (CN); ZHANG, Hui, Hefei Anhui 230601 (CN); FU, You, Hefei Anhui 230601 (CN); LEE, Tzung-Han, Hefei Anhui 230601 (CN)
(74) Representative: Gulde & Partner
(86) International application number: PCT/CN2024/103671
(87) International publication number: WO 2025/123656

(57) **Abstract**

A semiconductor structure and a manufacturing method therefor. The semiconductor structure includes: a first substrate and a semiconductor device located in the first substrate; a first conductive pad connected to multiple semiconductor devices; multiple second conductive pads, at least one of the first conductive pads and at least one of the second conductive pads being electrically connected through a first conductive interconnection structure extending in a direction perpendicular to the first substrate; and a filling layer filled in the outer periphery of each of the first conductive pads, the first conductive interconnection structure, and each of the second conductive pads, where the first conductive interconnection structure has a surface buried by a filling layer between adjacent second conductive pads. The semiconductor structure is at least conducive to improving electrical performance.

## Description

The present disclosure claims priority to Chinese Patent Application No. 202311728460.1, filed with the China National Intellectual Property Administration on December 14, 2023 and entitled "SEMICONDUCTOR STRUCTURE AND MANUFACTURING METHOD THEREFOR", which is incorporated herein by reference in its entirety.

### TECHNICAL FIELD

Embodiments of the present disclosure relate to the field of semiconductor technologies, and in particular, to a semiconductor structure and a manufacturing method therefor.

### BACKGROUND

With technological advances, the integration and consolidation of semiconductor packages have been gradually enhanced, and electronic devices are developing in the direction of miniaturization, high-speed, high-reliability, low-cost, and low-power consumption, and high bandwidth memory (HBM) products are in short supply. To realize high-capacity HBMs, a wafer on wafer (WoW) packaging technology or a chip-on-chip (CoC) packaging technology is required.

However, in a semiconductor packaging technology, secondary processing is required after wafer-level testing. In order to ensure a flat bonding interface, it is often necessary to achieve flatness by depositing a thick dielectric layer multiple times as well as chemical mechanical polishing, and on this basis, the dielectric layer is subjected to a deep hole etching or damascene process. The process is more complex, and deep hole etching is prone to metal contact problems caused by excessive by-products.

### SUMMARY

Embodiments of the present disclosure provide a semiconductor structure and a manufacturing method therefor, which at least helps improve electrical performance of the semiconductor structure.

According to some embodiments of the present disclosure, one aspect of the embodiments of the present disclosure provides a semiconductor structure, including: a first substrate and a semiconductor device located in the first substrate; multiple first conductive pads, connected to the semiconductor device; multiple second conductive pads, at least one of the first conductive pads and at least one of the second conductive pads being electrically connected through a first conductive interconnection structure extending in a direction perpendicular to the first substrate; and a filling layer, the filling layer being filled in the outer periphery of each of the first conductive pads, the first conductive interconnection structure, and each of the second conductive pads, where the first conductive interconnection structure has a surface buried by the filling layer between adjacent second conductive pads.

In some embodiments, the filling layer includes a first dielectric layer, a second dielectric layer, and a third dielectric layer, the first dielectric layer covers the first conductive pad, the third dielectric layer covers a sidewall of the second conductive pad, the second dielectric layer is located between the first dielectric layer and the third dielectric layer, a first predetermined height difference exists between the top surface of the second dielectric layer and the top surface of the first conductive interconnection structure, and a range of the first predetermined height difference is 0 nm to 50 nm.

In some embodiments, the first dielectric layer and the second dielectric layer constitute a sub-filling layer; and the filling layer further includes a fourth dielectric layer, and the fourth dielectric layer is located between the sub-filling layer and the first conductive interconnection structure.

In some embodiments, at least one of the second conductive pads is located on the top surface of the second dielectric layer.

In some embodiments, the second conductive pad located on the top surface of the second dielectric layer is not electrically connected to the first conductive pad, and the second conductive pad is in direct contact with the top surface of the second dielectric layer.

In some embodiments, the first conductive pad in electrical contact with the first conductive interconnection structure includes a first portion and a second portion, the second portion is in direct contact with the first conductive interconnection structure, the first portion is not in direct contact with the first conductive interconnection structure, and the surface of the second portion in direct contact with the first conductive interconnection structure has a portion lower than the surface of the first portion.

In some embodiments, orthographic projections of at least two of the first conductive pads on the first substrate overlap an orthographic projection of one first conductive interconnection structure on the first substrate.

In some embodiments, the filling layer includes a first bonding layer, the second conductive pad has a top surface exposed on the first bonding layer, a second predetermined height difference exists between the top surface of the second conductive pad exposed on the first bonding layer and the top surface of the first bonding layer, and a range of the second predetermined height difference is 0 nm to 50 nm.

In some embodiments, the semiconductor structure further includes a second bonding layer and a third conductive pad located in the second bonding layer, where the second bonding layer is directly bonded to the first bonding layer, and the third conductive pad is directly bonded to the second conductive pad.

In some embodiments, the semiconductor structure further includes an isolation layer, the isolation layer being located in the filling layer between adjacent first conductive pads.

According to some embodiments of the present disclosure, another aspect of the embodiments of the present disclosure further provides a manufacturing method for a semiconductor structure, including: providing a first substrate, the first substrate having a semiconductor device; forming multiple first conductive pads connected to the semiconductor device; forming a first opening, the first opening exposing the surface of at least one of the first conductive pads; forming a first conductive interconnection structure filling the first opening; and forming multiple second conductive pads on the first conductive interconnection structure, so that at least one of the first conductive pads and at least one of the second conductive pads are electrically connected through the first conductive interconnection structure; where a filling layer is formed on the outer periphery of each of the first conductive pads, each of the second conductive pads, and the first conductive interconnection structure, and the first conductive interconnection structure has a surface buried by a filling layer between adjacent second conductive pads.

In some embodiments, the filling layer includes a first dielectric layer, a second dielectric layer, and a third dielectric layer, the first conductive pad is formed in the first dielectric layer, the second dielectric layer is formed above the first dielectric layer, the first dielectric layer and the second dielectric layer are formed before the first opening is formed, and the first opening is formed in the first dielectric layer and the second dielectric layer; after the first conductive interconnection structure is formed in the first opening, flattening processing is performed on the surface of the first conductive interconnection structure, so that a first predetermined height difference exists between the top surface of the second dielectric layer and the top surface of the first conductive interconnection structure, where a range of the first predetermined height difference is 0 nm to 50 nm; and after the first conductive interconnection structure is formed, the third dielectric layer is formed, and the second conductive pad electrically connected to the first conductive interconnection structure is formed in the third dielectric layer.

In some embodiments, the filling layer further includes a fourth dielectric layer, the fourth dielectric layer is formed after the first opening is formed and before the first conductive interconnection structure is formed, so that the fourth dielectric layer is located between the first conductive interconnection structure and both of the first dielectric layer and the second dielectric layer.

In some embodiments, the step of forming the fourth dielectric layer includes: forming an initial fourth dielectric layer, the initial fourth dielectric layer conformally covering the surface of the first opening and the top surface of the second dielectric layer; and etching back the initial fourth dielectric layer to remove the initial fourth dielectric layer located on the top surface of the second dielectric layer and the bottom surface of the first opening, the remaining initial fourth dielectric layer being the fourth dielectric layer, where in the step of etching back the initial fourth dielectric layer, a partial thickness of the first conductive pad exposed by the first opening is etched away.

In some embodiments, the filling layer further includes a first bonding layer, the second conductive pad has a top surface exposed on the first bonding layer, a second predetermined height difference exists between the top surface of the second conductive pad exposed on the first bonding layer and the top surface of the first bonding layer, and a range of the second predetermined height difference is 0 nm to 50 nm; and after the forming the second conductive pad, the method further includes: forming a second bonding layer directly bonded to the first bonding layer and a third conductive pad directly bonded to the second conductive pad.

The technical solutions provided in the embodiments of the present disclosure have at least the following advantages:
An electrical signal in a semiconductor device is transferred to another electrical device through a first conductive pad, a first conductive interconnection structure, and a second conductive pad, or an electrical signal in another electrical device is transferred to a semiconductor device through a second conductive pad, a first conductive interconnection structure, and a first conductive pad. On this basis, the first conductive pad is mainly configured to implement an electrical connection to the semiconductor device, the second conductive pad is mainly configured to implement an electrical connection to another electrical device, and the first conductive interconnection structure is mainly configured to implement an electrical connection between the first conductive pad and the second conductive pad.

On this basis, the first conductive interconnection structure has a surface buried by a filling layer between adjacent second conductive pads. In other words, orthographic projections of at least two second conductive pads on a first substrate are designed to overlap an orthographic projection of one first conductive interconnection structure on the first substrate, so that one first conductive interconnection structure is in electrical contact with at least two second conductive pads. On one hand, transmission efficiency of an electrical signal in the first conductive pad, the first conductive interconnection structure, and the second conductive pad is improved. On the other hand, in the horizontal direction, the length of the first conductive interconnection structure is greater than the length of the second conductive pad, which helps improve alignment accuracy between the second conductive pad and the first conductive interconnection structure, thereby increasing a contact area between the second conductive pad and the first conductive interconnection structure, so as to reduce a contact resistance between the second conductive pad and the first conductive interconnection structure, thereby further improving transfer efficiency of the electrical signal.

### BRIEF DESCRIPTION OF DRAWINGS

One or more embodiments are exemplified with the figures in the accompanying drawings corresponding to the one or more embodiments. These example descriptions are not intended to limit the embodiments. Elements with the same reference numerals in the accompanying drawings are similar elements, and unless specifically stated, no scale limitations are constituted by the figures in the accompanying drawings. To describe the technical solutions in the embodiments of the present disclosure or the conventional technologies more clearly, the accompanying drawings required by the embodiments are briefly described below. Clearly, the accompanying drawings in the following description show merely some embodiments of the present disclosure, and other drawings may be obtained by a person of ordinary skill in the art from these accompanying drawings without creative efforts.
FIG. 1 is a schematic cross-sectional structural diagram of a semiconductor structure according to an embodiment of the present disclosure;
FIG. 2 is a schematic cross-sectional structural diagram of a first conductive interconnection structure and a filling layer in a semiconductor structure according to an embodiment of the present disclosure;
FIG. 3 is another schematic cross-sectional structural diagram of a semiconductor structure according to an embodiment of the present disclosure;
FIG. 4 is still another schematic cross-sectional structural diagram of a semiconductor structure according to an embodiment of the present disclosure;
FIG. 5 is yet another schematic cross-sectional structural diagram of a semiconductor structure according to an embodiment of the present disclosure;
FIG. 6 is a schematic cross-sectional structural diagram of a second conductive pad and a filling layer in a semiconductor structure according to an embodiment of the present disclosure;
FIG. 7 is another schematic cross-sectional structural diagram of a second conductive pad and a filling layer in a semiconductor structure according to an embodiment of the present disclosure;
FIG. 8 is yet another schematic cross-sectional structural diagram of a semiconductor structure according to an embodiment of the present disclosure;
FIG. 9 is a schematic cross-sectional structural diagram corresponding to each step in a manufacturing method for a semiconductor structure;
FIG. 10 is a schematic flowchart corresponding to a manufacturing method for a semiconductor structure according to another embodiment of the present disclosure; and
FIG. 11 to FIG. 27 are schematic cross-sectional structural diagrams corresponding to each step in a manufacturing method for a semiconductor structure according to another embodiment of the present disclosure.

### DESCRIPTION OF EMBODIMENTS

It may be learned from the background that electrical performance of a semiconductor structure needs to be improved.

The present disclosure provides a semiconductor structure and a manufacturing method therefor. In the semiconductor structure, a first conductive pad is mainly configured to implement an electrical connection to a semiconductor device, a second conductive pad is mainly configured to implement an electrical connection to another electrical device, and a first conductive interconnection structure is mainly configured to implement an electrical connection between the first conductive pad and the second conductive pad. On this basis, the first conductive interconnection structure has a surface buried by a filling layer between adjacent second conductive pads. In other words, orthographic projections of at least two second conductive pads on a first substrate are designed to overlap an orthographic projection of one first conductive interconnection structure on the first substrate, so that one first conductive interconnection structure is in electrical contact with at least two second conductive pads. On one hand, transmission efficiency of an electrical signal in the first conductive pad, the first conductive interconnection structure, and the second conductive pad is improved. On the other hand, in the horizontal direction, the length of the first conductive interconnection structure is greater than the length of the second conductive pad, which helps improve alignment accuracy between the second conductive pad and the first conductive interconnection structure, thereby increasing a contact area between the second conductive pad and the first conductive interconnection structure, so as to reduce a contact resistance between the second conductive pad and the first conductive interconnection structure, thereby further improving transfer efficiency of the electrical signal.

The embodiments of the present disclosure are described in detail below with reference to the accompanying drawings. However, it may be understood by a person of ordinary skill in the art that in the embodiments of the present disclosure, many technical details are provided to enable readers to better understand the embodiments of the present disclosure. However, the technical solutions claimed in the embodiments of the present disclosure may be implemented even without these technical details and various changes and modifications made based on the following embodiments.

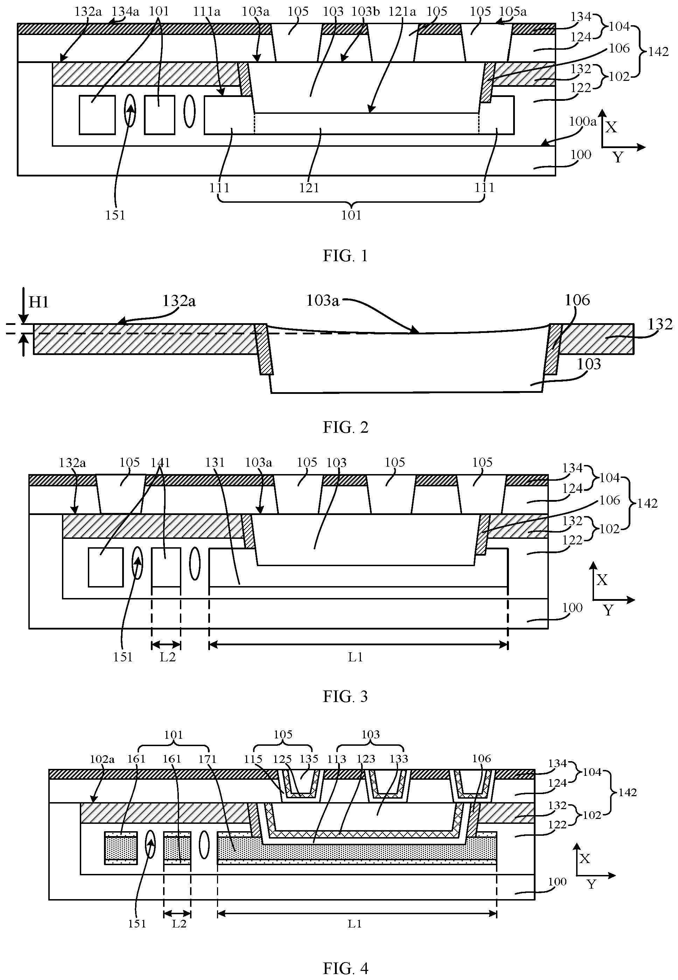

An embodiment of the present disclosure provides a semiconductor structure. The following describes in detail the semiconductor structure provided in an embodiment of the present disclosure with reference to the accompanying drawings. It should be noted that, for ease of description and a clear indication of a characteristic of a semiconductor structure, FIG. 1 to FIG. 8 in an embodiment of the present disclosure are all schematic local structural diagrams of the semiconductor structure.

Referring to FIG. 1, FIG. 1 is a schematic cross-sectional structural diagram of a semiconductor structure according to an embodiment of the present disclosure. The semiconductor structure includes a first substrate 100 and a semiconductor device (not shown in the figure) located in the first substrate 100; multiple first conductive pads 101, connected to the semiconductor device; multiple second conductive pads 105, at least one of the first conductive pads 101 and at least one of the second conductive pads 105 being electrically connected through a first conductive interconnection structure 103 extending in a direction X perpendicular to the first substrate 100; and a filling layer 142, the filling layer 142 being filled in the outer periphery of each of the first conductive pads 101, the first conductive interconnection structure 103, and each of the second conductive pads 105, where the first conductive interconnection structure 103 has a surface 103b buried by the filling layer 142 between adjacent second conductive pads 105. In some cases, an electrical signal in the semiconductor device is transferred to another electrical device through the first conductive pad 101, the first conductive interconnection structure 103, and the second conductive pad 105, or an electrical signal in another electrical device is transferred to the semiconductor device through the second conductive pad 105, the first conductive interconnection structure 103, and the first conductive pad 101. On this basis, the first conductive pad 101 is mainly configured to implement an electrical connection to the semiconductor device, the second conductive pad 105 is mainly configured to implement an electrical connection to another electrical device, and the first conductive interconnection structure 103 is mainly configured to implement an electrical connection between the first conductive pad 101 and the second conductive pad 105.

In addition, the first conductive interconnection structure 103 has a surface 103b buried by a filling layer 142 between adjacent second conductive pads 105, so that orthographic projections of at least two second conductive pads 105 on the first substrate 100 overlap an orthographic projection of the same first conductive interconnection structure 103 on the first substrate 100, and one first conductive interconnection structure 103 is in electrical contact with at least two second conductive pads 105. On this basis, a first conductive interconnection structure 103 connected to at least two adjacent second conductive pads 105 at the same time is designed. On one hand, such a design helps improve transmission efficiency of an electrical signal in the first conductive pad 101, the first conductive interconnection structure 103, and the second conductive pad 105. On the other hand, in the horizontal direction Y, the length of the first conductive interconnection structure 103 is greater than the length of a single second conductive pad 105, which helps improve alignment accuracy between the second conductive pad 105 and the first conductive interconnection structure 103. In addition, the single second conductive pad 105 is in electrical contact with the first conductive interconnection structure 103 as a whole, so that the contact area between the second conductive pad 105 and the first conductive interconnection structure 103 is increased, so as to reduce a contact resistance between the second conductive pad 105 and the first conductive interconnection structure 103, thereby further improving transfer efficiency of the electrical signal.

It should be noted that, referring to FIG. 1, the direction perpendicular to the first substrate 100 is the vertical direction X. In some cases, the vertical direction X may also be the direction in which the first conductive pad 101 points to the second conductive pad 105. The horizontal direction Y may be perpendicular to the vertical direction X. In addition, in FIG. 1, for example, one first conductive interconnection structure 103 is in electrical contact with three second conductive pads 105, two second conductive pads 105 in the three second conductive pads 105 are in electrical contact with the first conductive interconnection structure 103 as a whole, and a partial region of the remaining second conductive pad 105 is in electrical contact with the first conductive interconnection structure 103. In actual application, first, for any second conductive pad 105 in electrical contact with the first conductive interconnection structure 103, the contact area between the second conductive pad 105 and the first conductive interconnection structure 103 is not limited, that is, the entire region of the second conductive pad 105 may be in electrical contact with the first conductive interconnection structure 103, or a partial region of the second conductive pad 105 may be in electrical contact with the first conductive interconnection structure 103. Second, a quantity of second conductive pads 105 in electrical contact with the same first conductive interconnection structure 103 is not limited, provided that at least two is met.

In some embodiments, referring to FIG. 1, the semiconductor structure may further include an isolation layer 151, and at least a portion of the isolation layer 151 is located in the filling layer 142 between adjacent first conductive pads 101. In this way, an insulation effect between adjacent first conductive pads 101 is improved through an isolation layer 151 whose dielectric constant is lower than a dielectric constant of the filling layer 142, and crosstalk of signals on adjacent first conductive pads 101 is avoided.

In some embodiments, the isolation layer 151 may be an air gap.

In some embodiments, referring to FIG. 1 and FIG. 2, the filling layer 142 includes a first dielectric layer 122, a second dielectric layer 132, and a third dielectric layer 124, the first dielectric layer 122 covers the first conductive pad 101, the third dielectric layer 124 wraps the sidewall of the second conductive pad 105, the second dielectric layer 132 is located between the first dielectric layer 122 and the third dielectric layer 124, a first predetermined height difference H1 exists between the top surface 132a of the second dielectric layer 132 and the top surface 103a of the first conductive interconnection structure 103, and the range of the first predetermined height difference H1 is 0 nm to 50 nm.

FIG. 2 is a schematic cross-sectional structural diagram of a first conductive interconnection structure and a filling layer in a semiconductor structure according to an embodiment of the present disclosure. In some cases, referring to FIG. 1, the first predetermined height difference H1 may be 0 nm, that is, the top surface 132a of the second dielectric layer 132 is flush with the top surface 103a of the first conductive interconnection structure 103. In other cases, referring to FIG. 2, the top surface 103a of the first conductive interconnection structure 103 is a concave surface recessed in a direction closer to the first substrate 100 (referring to FIG. 1). In this case, the first predetermined height difference H1 is greater than 0 nm and less than or equal to 50 nm. In some other cases, the top surface of the first conductive interconnection structure may alternatively be a convex surface protruding in a direction away from the first substrate. In this case, the first predetermined height difference H1 is greater than 0 nm and less than or equal to 50 nm.

It should be noted that, in an embodiment of the present disclosure, it is only defined that the first predetermined height difference H1 exists between the top surface 132a of the second dielectric layer 132 and the top surface 103a of the first conductive interconnection structure 103. However, based on the first substrate 100, the height difference between the top surface 132a of the second dielectric layer 132 and the top surface 103a of the first conductive interconnection structure 103 is not limited, and may be adjusted according to an actual situation.

In addition, in FIG. 2, the first predetermined height difference H1 between the top surface 132a of the second dielectric layer 132 and the top surface 103a of the first conductive interconnection structure 103 is defined as the maximum vertical distance between each point in the top surface 132a of the second dielectric layer 132 and each point in the top surface 103a of the first conductive interconnection structure 103 in the vertical direction X. In addition, the surface 103b of the first conductive interconnection structure 103 buried by the filling layer 142 between adjacent second conductive pads 105 is a portion of the top surface 103a of the first conductive interconnection structure 103.

In some embodiments, referring to FIG. 1, the filling layer 142 includes a first dielectric layer 122 covering the first conductive pad 101, a third dielectric layer 124 covering the sidewall of the second conductive pad 105, and a second dielectric layer 132 located between the first dielectric layer 122 and the third dielectric layer 124. On this basis, the isolation layer 151 is located in the first dielectric layer 122, that is, the first dielectric layer 122 has the isolation layer 151. It should be noted that, in actual application, the isolation layer may be further located in the second dielectric layer.

In some embodiments, referring to FIG. 1, the first dielectric layer 122 and the second dielectric layer 132 constitute a sub-filling layer 102. The filling layer 142 may further include a fourth dielectric layer 106, and the fourth dielectric layer 106 is located between the sub-filling layer 102 and the first conductive interconnection structure 103.

In some cases, in the step of forming the first conductive interconnection structure 103, a first opening accommodating the first conductive interconnection structure 103 needs to be formed in the sub-filling layer 102, and the fourth dielectric layer 106 is utilized to protect the sidewall of the first opening, so as to avoid etching of the sub-filling layer 102 forming the sidewall of the first opening, so that the sidewall of the first opening has a relatively flat interface, so that the first conductive interconnection structure 103 with a regular size is subsequently formed.

In some embodiments, referring to FIG. 3, FIG. 3 is another schematic cross-sectional structural diagram of a semiconductor structure according to an embodiment of the present disclosure. At least one second conductive pad 105 is located on the top surface 132a of the second dielectric layer 132. In some examples, at least one second conductive pad 105 may be in contact with the top surface 132a of the second dielectric layer 132. In some other embodiments, at least one second conductive pad 105 may not be in direct contact with the top surface 132a of the second dielectric layer 132.

It should be noted that the second conductive pad 105 in contact with the top surface 132a of the second dielectric layer 132 is not electrically connected to the first conductive pad 101. Further, the second conductive pad 105 in contact with the top surface 132a of the second dielectric layer 132 may not be electrically connected to the semiconductor device, that is, the second conductive pad 105 in contact with the top surface 132a of the second dielectric layer 132 may not transfer an electrical signal.

In this case, on one hand, if the second conductive pad 105 is bonded to an external film layer structure, the external film layer structure includes another conductive pad, signal transfer is performed between some other conductive pads and the second conductive pad 105 in electrical contact with the first conductive interconnection structure 103, but there is another remaining conductive pad in the external film layer structure, the second conductive pad 105 in contact with the top surface 132a of the second dielectric layer 132 is designed to balance the distribution density of the conductive pads in the external film layer structure and the distribution density of the second conductive pads 105 in the third dielectric layer 124, so that when the second conductive pad 105 is bonded to the external film layer structure, two bonding interfaces in contact with each other of the two are affected by a similar degree of thermal expansion, thereby improving bonding strength between the second conductive pad 105 and the external film layer structure, to improve contact performance between the second conductive pad 105 and the external film layer structure.

On the other hand, if the second conductive pad 105 is bonded to an external film layer structure, the thermal expansion coefficient of the external film layer structure is different from the overall thermal expansion coefficient of the second conductive pad 105 and the third dielectric layer 124, the second conductive pad 105 in contact with the top surface 132a of the second dielectric layer 132 is designed, helping adjust the distribution density of the second conductive pads 105 in the third dielectric layer 124, so that when the second conductive pad 105 is bonded to the external film layer structure, two bonding interfaces in contact with each other of the two are affected by a similar degree of thermal expansion, thereby improving bonding strength between the second conductive pad 105 and the external film layer structure, to improve contact performance between the second conductive pad 105 and the external film layer structure.

In some embodiments, referring to FIG. 1, the first conductive pad 101 in electrical contact with the first conductive interconnection structure 103 includes a first portion 111 and a second portion 121, the second portion 121 is in direct contact with the first conductive interconnection structure 103, the first portion 111 is not in direct contact with the first conductive interconnection structure 103, and the surface of the second portion 121 in direct contact with the first conductive interconnection structure 103 has a portion lower than the surface of the first portion 111.

In some cases, the top surface 100a of the first substrate 100 is utilized as a reference, and the top surface 121a of the second portion 121 is lower than the top surface 111a of the first portion 111.

The correspondence between the first conductive pad 101 and the first conductive interconnection structure 103 includes at least the following two embodiments:
In some embodiments, referring to FIG. 1 or FIG. 3, an orthographic projection of only one first conductive pad 101 on the first substrate 100 overlaps an orthographic projection of one first conductive interconnection structure 103 on the first substrate 100, that is, the first conductive pad 101 and the first conductive interconnection structure 103 are in a one-to-one relationship.

It should be noted that in both FIG. 1 and FIG. 3, for example, in the horizontal direction Y, the length of the first conductive pad 101 is greater than the length of the first conductive pad 101 in electrical contact with the first conductive interconnection structure 103. In actual application, when the first conductive pad 101 and the first conductive interconnection structure 103 are in a one-to-one relationship, the size relationship between the first conductive pad 101 and the first conductive interconnection structure 103 in the horizontal direction Y is not limited.

In some cases, when the first conductive pad 101 and the first conductive interconnection structure 103 are in a one-to-one relationship, the first conductive pad 101 may be a wiring layer, and the wiring layer may be located in a peripheral region of the semiconductor structure. Referring to FIG. 3, the first conductive pad 101 includes a first wiring layer 131 and a second wiring layer 141. In the length direction Y, a first length L1 of the first wiring layer 131 is greater than a second length L2 of the second wiring layer 141.

It should be noted that the first wiring layer 131 and the second wiring layer 141 in the first conductive pad 101 may be considered as the same layer structure, that is, both are located in a film layer interval in which the first conductive pad 101 is located. However, the first wiring layer 131 and the second wiring layer 141 may be insulated from each other, so as to implement an electrical connection between unused conductive structures. In addition, in addition to the first wiring layer 131 and the second wiring layer 141, the first conductive pad 101 may further include a third wiring layer, a fourth wiring layer, a fifth wiring layer, or the like. In addition, the first wiring layer 131 and the second wiring layer 141 may be integrally formed, that is, except for implementing different functions, e.g., electrically connected to different semiconductor devices, the first wiring layer 131 and the second wiring layer 141 have the same film layer structure and material. In FIG. 3, the first wiring layer 131 and the second wiring layer 141 are drawn in the same filling manner.

In some embodiments, still referring to FIG. 3, in the horizontal direction Y, the first wiring layer 131 and the second wiring layer 141 may further have an isolation layer 151 therebetween. For example, the first dielectric layer 122 has an isolation layer 151, which helps improve an insulation effect between the first wiring layer 131 and the second wiring layer 141 through the isolation layer 151.

In some embodiments, referring to FIG. 4, FIG. 4 is still another schematic cross-sectional structural diagram of a semiconductor structure according to an embodiment of the present disclosure. In some embodiments, the first conductive pad 101 includes a barrier layer 161 and a conductive layer 171. In the vertical direction X, the conductive layer 171 has opposite first and second sides, and the barrier layer 161 covers at least the first and second sides.

It may be understood that the barrier layer 161 is configured to prevent conductive ions in the conductive layer 171 from diffusing and migrating to the sub-filling layer 102, so as to avoid a decrease in conductive performance of the conductive layer 171 due to diffusion and migration of the conductive ions, and avoid a decrease in insulation performance of the sub-filling layer 102 due to migration-in of the conductive ions, thereby ensuring relatively high conductivity of the conductive layer 171 and relatively high insulation performance of the sub-filling layer 102.

It should be noted that, with reference to FIG. 3 and FIG. 4, both the first wiring layer 131 and the second wiring layer 141 may include a barrier layer 161 and a conductive layer 171. In actual application, the first conductive pad 101 may alternatively include only the conductive layer 171.

In some embodiments, the material of the barrier layer 161 is at least one of titanium or titanium nitride, and the material of the conductive layer 171 is aluminum. In this way, the barrier layer 161 helps prevent electromigration of aluminum ions.

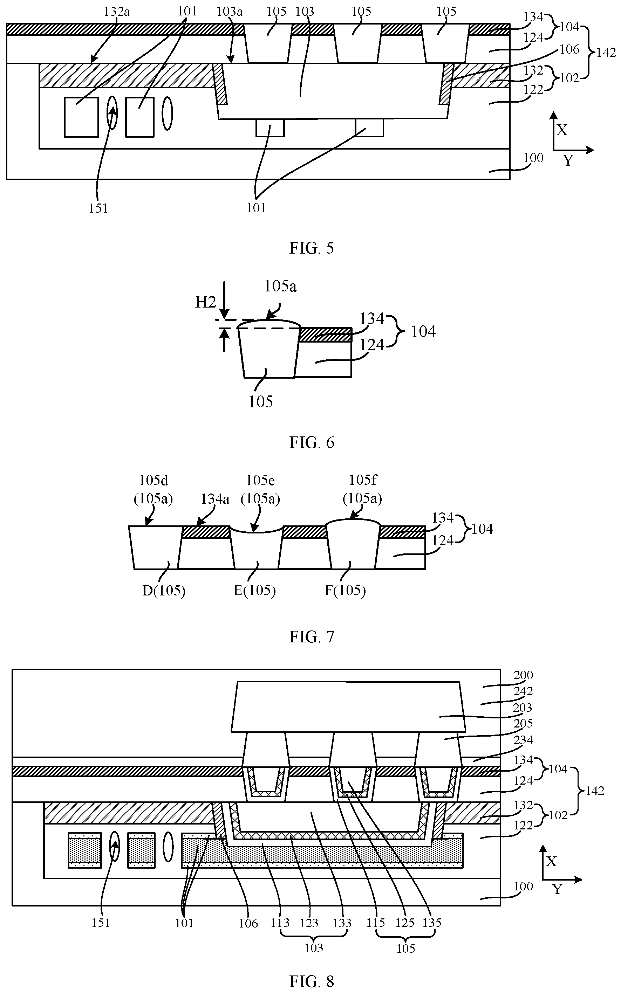

In some other embodiments, referring to FIG. 5, FIG. 5 is yet another schematic cross-sectional structural diagram of a semiconductor structure according to an embodiment of the present disclosure. Orthographic projections of at least two first conductive pads 101 on the first substrate 100 overlap an orthographic projection of one first conductive interconnection structure 103 on the first substrate 100. In this way, one first conductive interconnection structure 103 is in electrical contact with at least two first conductive pads 101. On one hand, transmission efficiency of an electrical signal in the first conductive pad 101, the first conductive interconnection structure 103, and the second conductive pad 105 is improved. On the other hand, in the horizontal direction Y, the length of the first conductive interconnection structure 103 is greater than the length of a single first conductive pad 101, which helps improve alignment accuracy between the first conductive pad 101 and the first conductive interconnection structure 103. In addition, the single first conductive pad 101 is in electrical contact with the first conductive interconnection structure 103 as a whole, so that the contact area between the first conductive pad 101 and the first conductive interconnection structure 103 is increased, so as to reduce a contact resistance between the first conductive pad 101 and the first conductive interconnection structure 103, thereby further improving transfer efficiency of the electrical signal.

In still some other embodiments, one first conductive pad 101 is correspondingly connected to one first conductive interconnection structure 103, so as to independently form a connection path between each first conductive pad 101 and a corresponding second conductive pad 105.

In some cases, when the first conductive pad 101 and the first conductive interconnection structure 103 are in a multiple-to-one relationship, the first conductive pad 101 may be a signal lead-out layer. For example, the signal lead-out layer may be an I/O signal lead-out layer, a power signal lead-out layer, or another type of signal lead-out layer.

In some embodiments, with reference to FIG. 1 and FIG. 6, or with reference to FIG. 1 and FIG. 7, the filling layer 142 may further include a first bonding layer 134. The second conductive pad 105 has a top surface 105a exposed on the first bonding layer 134. A second predetermined height difference H2 exists between the top surface 105a of the second conductive pad 105 exposed on the first bonding layer 134 and the top surface 134a of the first bonding layer 134, and the range of the second predetermined height difference H2 is 0 nm to 50 nm.

In some cases, the third dielectric layer 124 and the first bonding layer 134 jointly constitute the dielectric layer 104, and the second conductive pad 105 penetrates the dielectric layer 104 in the vertical direction X.

In some cases, referring to the second conductive pad D in FIG. 1 or FIG. 7, the second predetermined height difference H2 (referring to FIG. 6) may be 0 nm, that is, the top surface 134a of the first bonding layer 134 is flush with the top surface 105d of a second conductive pad D or the top surface 105a of the second conductive pad 105 in FIG. 1. In some other cases, referring to FIG. 7, the top surface 105e of the second conductive pad E is a concave surface recessed in a direction closer to the first substrate 100 (referring to FIG. 1). In this case, the second predetermined height difference H2 (referring to FIG. 6) is greater than 0 nm and less than or equal to 50 nm. In still some other cases, referring to a second conductive pad F in FIG. 6 or FIG. 7, the top surface 105a of the second conductive pad 105 is a convex surface protruding in a direction away from the first substrate 100 (referring to FIG. 1). In this case, the second predetermined height difference H2 (referring to FIG. 6) is greater than 0 nm and less than or equal to 50 nm.

It should be noted that FIG. 6 is a schematic cross-sectional structural diagram of a second conductive pad and a filling layer in a semiconductor structure according to an embodiment of the present disclosure. FIG. 7 is another schematic cross-sectional structural diagram of a second conductive pad and a filling layer in a semiconductor structure according to an embodiment of the present disclosure. In addition, to distinguish three different second conductive pads 105 in FIG. 7, the three different second conductive pads 105 in FIG. 7 are respectively marked as D, E, and F, and the top surfaces 105a of the three different second conductive pads 105 are respectively marked as 105d, 105e, and 105f.

It should be noted that, in an embodiment of the present disclosure, it is only defined that the second predetermined height difference H2 exists between the top surface 134a of the first bonding layer 134 and the top surface 105a of the second conductive pad 105. However, utilizing the first substrate 100 as a reference, the height difference between the top surface 134a of the first bonding layer 134 and the top surface 105a of the second conductive pad 105 is not limited, and may be adjusted according to an actual situation.

In addition, in FIG. 6, the second predetermined height difference H2 between the top surface 134a of the first bonding layer 134 and the top surface 105a of the second conductive pad 105 is defined as the maximum vertical distance between each point in the top surface 134a of the first bonding layer 134 and each point in the top surface 105a of the second conductive pad 105 in the vertical direction X.

It should be noted that in FIG. 7, only an example is utilized to describe different topography of the top surface 105a of the second conductive pad 105. The topography of the top surfaces 105a of different second conductive pads 105 in the same semiconductor structure may be the same or may be different, which may be adjusted according to an actual situation.

In some cases, when the first conductive pad 101 is an I/O signal lead-out layer, in the horizontal direction Y, a spacing between adjacent first conductive pads 101 is relatively small and the length of the first conductive pad 101 itself is relatively small, so that a spacing between adjacent second conductive pads 105 corresponding to the first conductive pads 101 is also relatively small and the length of the second conductive pad 105 itself is relatively small. On this basis, a process parameter for preparing the second conductive pad 105 is adjusted, and the top surface 105a of the second conductive pad 105 is designed to be similar to that shown in FIG. 6, that is, a convex surface protruding in the direction away from the first substrate 100 (referring to FIG. 1). Therefore, in a case in which the length of the second conductive pad 105 in the horizontal direction Y is relatively small, alignment precision of bonding the second conductive pad 105 subsequently to a conductive pad in an external film layer structure is improved, and the contact area between the second conductive pad 105 and the conductive pad in the external film layer structure is increased, so as to improve transfer efficiency of an electrical signal between the two.

In some embodiments, referring to FIG. 4, the filling layer 142 includes a first dielectric layer 122 and a second dielectric layer 132, the first dielectric layer 122 and the second dielectric layer 132 constitute a sub-filling layer 102, and the sub-filling layer 102 has a first opening wrapping the first conductive interconnection structure 103. The first conductive interconnection structure 103 includes a first diffusion barrier layer 113, conformally covering the sidewall and the bottom surface of the first opening; a first seed layer 123, conformally covering the sidewall and the bottom surface of the first diffusion barrier layer 113; and a first plating layer 133, filling the remaining portion of the first opening.

It should be noted that the first diffusion barrier layer 113 is configured to prevent conductive ions in the first seed layer 123 and the first plating layer 133 from diffusing and migrating to the sub-filling layer 102, so as to avoid a decrease in conductive performance of the first seed layer 123 and the first plating layer 133 due to diffusion and migration of the conductive ions, and a decrease in insulation performance of the sub-filling layer 102 due to migration-in of the conductive ions. That is, it is ensured that the conductive performance of the first seed layer 123 and the first plating layer 133 is relatively high and the insulation performance of the sub-filling layer 102 is relatively high.

In some cases, the material of the first diffusion barrier layer 113 is at least one of tantalum or tantalum nitride, and the material of the first seed layer 123 and the first plating layer 133 is copper. In this way, the first diffusion barrier layer 113 helps prevent electromigration of copper ions.

In some embodiments, still referring to FIG. 4, the filling layer 142 includes a third dielectric layer 124, and the third dielectric layer 124 has a second opening wrapping the second conductive pad 105. The second conductive pad 105 includes a second diffusion barrier layer 115, conformally covering the sidewall and the bottom surface of the second opening, a second seed layer 125, conformally covering the sidewall and the bottom surface of the second diffusion barrier layer 115, and a second plating layer 135, filling the remaining portion of the second opening.

It should be noted that the second diffusion barrier layer 115 is configured to prevent conductive ions in the second seed layer 125 and the second plating layer 135 from diffusing and migrating to the third dielectric layer 124, so as to avoid a decrease in conductive performance of the second seed layer 125 and the second plating layer 135 due to diffusion and migration of the conductive ions, and a decrease in insulation performance of the third dielectric layer 124 due to migration-in of the conductive ions. That is, it is ensured that conductivity of the second seed layer 125 and the second plating layer 135 is relatively high, and insulation performance of the third dielectric layer 124 is relatively high.

In some embodiments, the material of the second diffusion barrier layer 115 is at least one of tantalum or tantalum nitride, and the material of the second seed layer 125 and the second plating layer 135 is copper. In this way, the second diffusion barrier layer 115 helps prevent electromigration of copper ions.

It should be noted that in FIG. 4, the first diffusion barrier layer 113 and the second diffusion barrier layer 115 are drawn in the same filling manner. In actual application, materials of the first diffusion barrier layer 113 and the second diffusion barrier layer 115 may be the same or different.

In some embodiments, referring to FIG. 8, FIG. 8 is still another schematic cross-sectional structural diagram of a semiconductor structure according to an embodiment of the present disclosure. The semiconductor structure may further include a second bonding layer 234 and a third conductive pad 205 located in the second bonding layer 234. The second bonding layer 234 is directly bonded to the first bonding layer 134, and the third conductive pad 205 is directly bonded to the second conductive pad 105.

It should be noted that no adhesive is utilized for direct bonding between the second bonding layer 234 and the first bonding layer 134, and direct bonding between the third conductive pad 205 and the second conductive pad 105 may implement an electrical connection between the two.

In some embodiments, the third conductive pad 205 and the second conductive pad 105 may be in a one-to-one correspondence.

It should be noted that, in FIG. 8, for example, orthographic projections of the third conductive pad 205 and the second conductive pad 105 on the first substrate 100 overlap each other. In actual application, the size relationship between areas of the orthographic projections of the third conductive pad 205 and the second conductive pad 105 on the first substrate 100 is not limited, and may be adjusted according to an actual requirement. In addition, referring to FIG. 4, a film structure inside the third conductive pad 205 is similar to a film structure inside the second conductive pad 105, and details are not described herein. In other words, the third conductive pad 205 also includes a diffusion barrier layer, a seed layer, and a plating layer.

In some embodiments, referring to FIG. 8, the semiconductor structure may further include: a second conductive interconnection structure 203, where at least one third conductive pad 205 is in electrical contact with the same second conductive interconnection structure 203; a second filling layer 242, where the second filling layer 242 is filled in the outer periphery and an interval of each third conductive pad 205 and the second conductive interconnection structure 203; and a second substrate 200, where the second filling layer 242 is located in the second substrate 200.

It should be noted that, in FIG. 8, for example, the three third conductive pads 205 are in electrical contact with the same second conductive interconnection structure 203. In actual application, a quantity of third conductive pads 205 in electrical contact with the same second conductive interconnection structure 203 is not limited, and may be adjusted according to an actual situation. In addition, the third conductive pad 205 is the another conductive pad in the external film layer structure described in the foregoing embodiment.

In some cases, the first substrate 100, the filling layer 142 located in the first substrate 100, and the first conductive pad 101, the first conductive interconnection structure 103, and the second conductive pad 105 that are located in the filling layer 142 are all components of a first semiconductor chip. The second substrate 200, the second filling layer 242 located in the second substrate 200, and the second conductive interconnection structure 203 and the third conductive pad 205 that are located in the second filling layer 242 are all components of a second semiconductor chip. The first semiconductor chip and the second semiconductor chip are bonded at the first bonding layer 134, and an electrical signal is transferred through a bonding connection between the second conductive pad 105 and the third conductive pad 205.

It should be noted that, first, referring to FIG. 4, a film layer structure inside the second conductive interconnection structure 203 is similar to a film layer structure inside the first conductive interconnection structure 103, and details are not described herein. In other words, the second conductive interconnection structure 203 also includes a diffusion barrier layer, a seed layer, and a plating layer. Second, referring to FIG. 4, the film layer structure inside the second filling layer 242 is similar to a film layer structure inside the filling layer 142, and details are not described herein. In other words, the second filling layer 242 also includes multiple dielectric layers. Third, a semiconductor device contained in the second substrate 200 and a semiconductor device contained in the first substrate 100 may be the same or different. If the semiconductor device contained in the second substrate 200 and the semiconductor device contained in the first substrate 100 are the same, the first semiconductor chip and the second semiconductor chip are of the same type. If the semiconductor device contained in the second substrate 200 and the semiconductor device contained in the first substrate 100 are different, the first semiconductor chip and the second semiconductor chip are of different types.

In conclusion, the first conductive pad 101 is mainly configured to implement an electrical connection to the semiconductor device, the second conductive pad 105 is mainly configured to implement an electrical connection to another electrical device, and the first conductive interconnection structure 103 is mainly configured to implement an electrical connection between the first conductive pad 101 and the second conductive pad 105. On this basis, it is designed that orthographic projections of at least two second conductive pads 105 on the first substrate 100 overlap an orthographic projection of the first conductive interconnection structure 103 on the first substrate 100, so that one first conductive interconnection structure 103 is in electrical contact with at least two second conductive pads 105. On one hand, this helps improve transmission efficiency of an electrical signal in the first conductive pad 101, the first conductive interconnection structure 103, and the second conductive pad 105. On the other hand, in the horizontal direction Y, the length of the first conductive interconnection structure 103 is greater than the length of a single second conductive pad 105, which helps improve alignment accuracy between the second conductive pad 105 and the first conductive interconnection structure 103. In addition, the single second conductive pad 105 is in electrical contact with the first conductive interconnection structure 103 as a whole, so that the contact area between the second conductive pad 105 and the first conductive interconnection structure 103 is increased, so as to reduce a contact resistance between the second conductive pad 105 and the first conductive interconnection structure 103, thereby further improving transfer efficiency of the electrical signal.

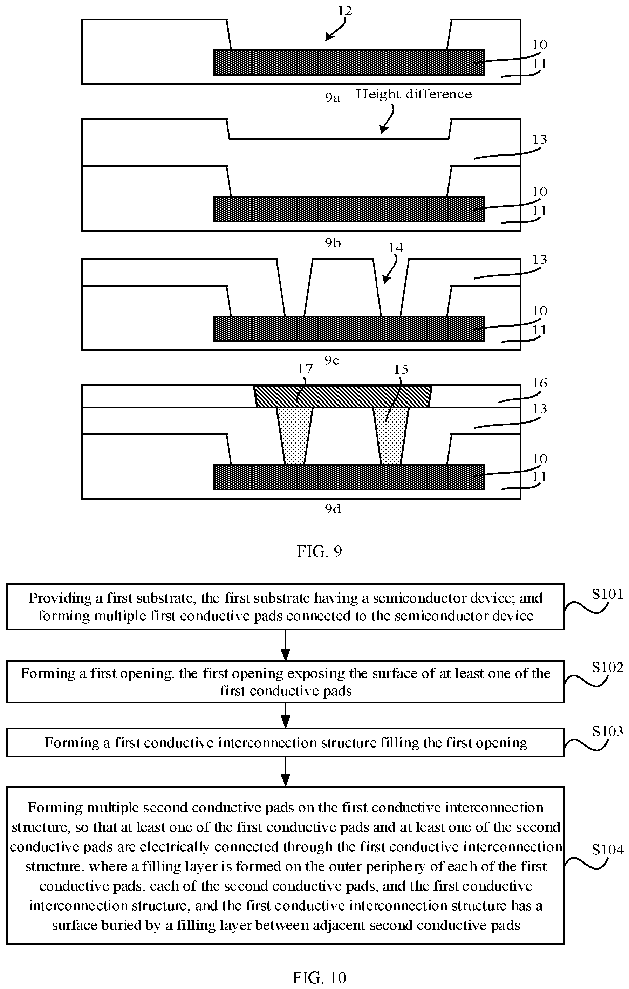

Another embodiment of the present disclosure further provides a manufacturing method for a semiconductor structure, which is configured to prepare the semiconductor structure described in the foregoing embodiment. The following describes in detail the manufacturing method for a semiconductor structure provided in another embodiment of the present disclosure with reference to the accompanying drawings. It should be noted that a portion same as or corresponding to the foregoing embodiment is not described herein again. It is found through analysis that, referring to 9a in FIG. 9, to lead out an electrical connection layer 10 in the semiconductor structure, after the electrical connection layer 10 and the first isolation layer 11 wrapping the electrical connection layer 10 are formed, the first isolation layer 11 is graphically processed, so as to form an opening 12 exposing the electrical connection layer 10. In this graphical processing step, etching damage is easily caused to the surface exposed by the electrical connection layer 10, which affects subsequent electrical connection performance of the electrical connection layer 10 and a conductive pillar.

It should be noted that 9a to 9d in FIG. 9 are each a schematic cross-sectional structural diagram corresponding to each step in a manufacturing method for a semiconductor structure.

With reference to 9a and 9b in FIG. 9, a second isolation layer 13 of a large block is deposited in the opening 12. In this deposition step, because of existence of the opening 12, there is a relatively large height difference between the second isolation layer 13 formed on the top surface of the first isolation layer 11 and the second isolation layer 13 formed at the opening 12, that is, step high.

With reference to 9b and 9c in FIG. 9, chemical mechanical polishing (CMP) is performed on the second isolation layer 13. A relatively large height difference exists between second isolation layers 13 in different regions shown in FIG. 9b, which makes it difficult for chemical mechanical polishing to achieve a flat surface of the second isolation layer 13.

Referring to 9c in FIG. 9, graphical processing is performed on the second isolation layer 13 obtained after chemical mechanical polishing to form a via 14 exposing the electrical connection layer 10. To expose the electrical connection layer 10, the depth-to-width ratio of the via 14 is relatively large, so that in the step of forming the via 14 by etching the second isolation layer 13, etching by-products formed in the via 14 are not easily removed, and thus there is an etching residue in the via 14.

With reference to 9c and 9d in FIG. 9, a conductive pillar 15 is formed in the via 14, and it is easy to reduce conductivity of the conductive pillar 15 due to the existence of the etching residue, that is, an increase in the overall resistance of the conductive pillar 15. Therefore, it is further easy to cause poor contact between the conductive pillar 15 and the electrical connection layer 10.

Referring to 9d in FIG. 9, a third isolation layer 16 is formed, and a conductive layer 17 is formed in the third isolation layer 16 through a damascene process.

It may be learned from the foregoing description that, to lead out the electrical connection layer 10 in the semiconductor structure, dielectric layers (e.g. the first isolation layer 11, the second isolation layer 13, and the third isolation layer 16) need to be deposited for multiple times and chemical mechanical polishing is often required to achieve a flat objective. In this step, the difficulty of chemical mechanical polishing depends on the uniformity of a film layer of a formed isolation layer. In addition, on this basis, deep hole etching, a damascene process, and the like are performed on the isolation layer, and a process procedure is relatively complex. In addition, deep hole etching tends to cause the problem of poor contact between the electrical connection layer 10 and the conductive pillar 15 caused by excessive by-products.

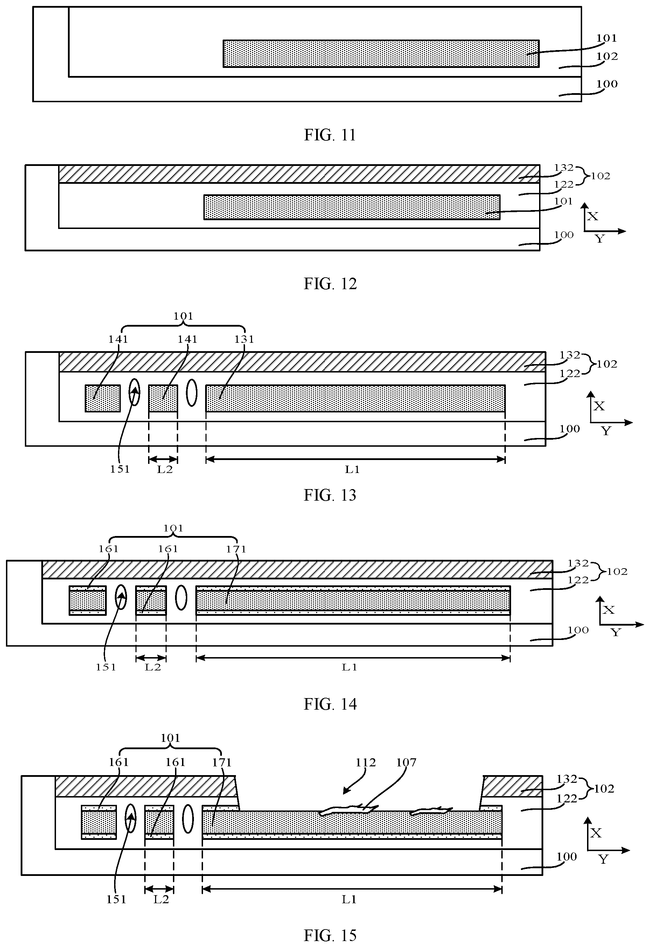

Another embodiment of the present disclosure provides a manufacturing method for a semiconductor structure. The following describes in detail the manufacturing method for a semiconductor structure provided in another embodiment of the present disclosure with reference to the accompanying drawings. FIG. 10 is a schematic flowchart corresponding to a manufacturing method for a semiconductor structure according to another embodiment of the present disclosure. FIG. 11 to FIG. 27 are schematic cross-sectional structural diagrams corresponding to each step in a manufacturing method for a semiconductor structure according to another embodiment of the present disclosure. It should be noted that, to facilitate description and clearly show steps of the manufacturing method for a semiconductor structure, FIG. 11 to FIG. 27 in this embodiment are all schematic local structural diagrams of the semiconductor structure.

Referring to FIG. 10 to FIG. 27, a manufacturing method for a semiconductor structure includes the following steps: S101: a first substrate 100 is provided, the first substrate 100 having a semiconductor device, and multiple first conductive pads 101 connected to the semiconductor device are formed; S102: a first opening 112 is formed, the first opening 112 exposing the surface of at least one of the first conductive pads 101; S103: a first conductive interconnection structure 103 filling the first opening 112 is formed; S104: multiple second conductive pads 105 are formed on the first conductive interconnection structure 103, so that at least one of the first conductive pads 101 and at least one of the second conductive pads 105 are electrically connected through the first conductive interconnection structure 103.

A filling layer 142 is formed on the outer periphery of each of the first conductive pads 101, each of the second conductive pads 105, and the first conductive interconnection structure 103, and the first conductive interconnection structure 103 has a surface 103b buried by a filling layer 142 between adjacent second conductive pads 105 (referring to FIG. 1).

It may be understood that, first, after the first opening 112 exposing the first conductive pad 101 is formed, an isolation layer filling the first opening 112 is no longer formed, so as to avoid the problem of step high in a subsequently formed isolation layer, and further reduce the step of chemical mechanical polishing once, thereby simplifying a process step of preparing a semiconductor structure. Second, the first conductive interconnection structure 103 may be formed in the first opening 112. On one hand, it helps to increase the contact area between the first conductive interconnection structure 103 and the first conductive pad 101, so as to reduce a contact resistance between the first conductive interconnection structure 103 and the first conductive pad 101. On the other hand, the first conductive interconnection structure 103 in contact with and connected to the first conductive pad 101 does not need to be formed in a deep hole etching manner, so as to avoid existence of an etching by-product between the first conductive pad 101 and the first conductive interconnection structure 103 or in the first conductive interconnection structure 103, thereby helping improve conductivity of the first conductive interconnection structure 103, reducing a contact resistance between the first conductive interconnection structure 103 and the first conductive pad 101, and avoiding poor contact between the first conductive interconnection structure 103 and the first conductive pad 101.

In some embodiments, still referring to FIG. 10 to FIG. 27, the filling layer 142 may include a first dielectric layer 122, a second dielectric layer 132, and a third dielectric layer 124. The first conductive pad 101 is formed in the first dielectric layer 122, the second dielectric layer 132 is formed above the first dielectric layer 122, the first dielectric layer 122 and the second dielectric layer 132 are formed before the first opening 112 is formed, and the first opening 112 is formed in the first dielectric layer 122 and the second dielectric layer 132. Subsequently, how to form the first conductive pad 101 is described in detail.

The following describes steps in the manufacturing method provided in an embodiment of the present disclosure in more detail with reference to the accompanying drawings. Referring to FIG. 11 to FIG. 18, S101: a first substrate 100 is provided, the first substrate 100 having a semiconductor device; and multiple first conductive pads 101 connected to the semiconductor device are formed. S102: A first opening 112 is formed, the first opening 112 exposing the surface of at least one of the first conductive pads 101.

In some embodiments, the filling layer 142 includes a sub-filling layer 102 wrapping the first conductive pad 101, and the sub-filling layer 102 has a first opening 112 exposing at least a portion of the top surface of the first conductive pad 101.

In some embodiments, forming the sub-filling layer 102 with the first opening 112 includes the following steps:
Referring to FIG. 11 to FIG. 14, a first substrate 100 that does not form a first opening 112 (referring to FIG. 15) includes a first conductive pad 101 and a sub-filling layer 102 wrapping the first conductive pad 101. It should be noted that the sub-filling layer 102 shown in FIG. 11 to FIG. 14 wraps each surface of the first conductive pad 101, and subsequently a first opening 112 is formed inside the sub-filling layer 102. For ease of description, the reference numeral of the sub-filling layer after the first opening 112 is formed in FIG. 12 to FIG. 14 and subsequent FIG. 15 to FIG. 27 are not distinguished.

In some embodiments, referring to FIG. 12, the sub-filling layer 102 includes a first dielectric layer 122 and a second dielectric layer 132 that are stacked in the vertical direction X, and the first dielectric layer 122 wraps the first conductive pad 101. It should be noted that both the first dielectric layer 122 and the second dielectric layer 132 in FIG. 12 and subsequent FIG. 13 and FIG. 14 are a first dielectric layer and a second dielectric layer before the first opening 112 is formed. For ease of description, reference numerals of the first dielectric layer and the second dielectric layer after the first opening 112 is formed in FIG. 12 to FIG. 14 and subsequent FIG. 15 to FIG. 27 are not distinguished.

It may be understood that in addition to the first conductive pad 101, the semiconductor structure includes another semiconductor device, such as a transistor structure, a word line, a bit line, and a capacitor structure. The first dielectric layer 122 and the second dielectric layer 132 jointly implement electrical insulation between the first conductive pad 101 and another semiconductor device in the semiconductor structure.

In some embodiments, the material of the first dielectric layer 122 is silicon oxide, and the material of the second dielectric layer 132 is silicon nitride. In this way, when silicon oxide is applied to improve electrical insulation performance between the first conductive pad 101 and another conductive structure in the semiconductor structure, silicon nitride is applied to improve hardness of the sub-filling layer 102 wrapping the first conductive pad 101, that is, improve the overall structural stability of the sub-filling layer 102.

In some embodiments, referring to FIG. 13, the first conductive pad 101 may include a first wiring layer 131 and a second wiring layer 141. In the horizontal direction Y, a first length L1 of the first wiring layer 131 is greater than a second length L2 of the second wiring layer 141, and a first opening 112 formed subsequently exposing a portion of the surface of the first conductive pad 101 exposed includes: the first opening 112 exposing a portion of the surface of the first wiring layer 131.

In some cases, the first conductive pad 101 may be a wiring layer, and the wiring layer may be located in the peripheral region of the semiconductor structure. In an example, the wiring layer includes the first wiring layer 131 and the second wiring layer 141. On this basis, subsequently formed first conductive pad 101 and first conductive interconnection structure 103 are in a one-to-one relationship.

It may be understood that the subsequently formed first opening 112 exposes the first wiring layer 131 to be subsequently connected to an electrical connection layer in another semiconductor structure, so as to implement an electrical connection between two semiconductor structures. The second wiring layer 141 located in the sub-filling layer 102 may be configured to implement an electrical connection between two conductive structures in the same semiconductor structure. In addition, in the horizontal direction Y, the first length L1 of the first wiring layer 131 is greater than the second length L2 of the second wiring layer 141, which facilitates subsequently forming a first opening 112 with a relatively large size, so as to expose the first wiring layer 131 with a larger area.

It should be noted that the first wiring layer 131 and the second wiring layer 141 in the first conductive pad 101 may be considered as the same layer structure, that is, both are located in a film layer interval in which the first conductive pad 101 is located. However, the first wiring layer 131 and the second wiring layer 141 may be insulated from each other, so as to implement an electrical connection between unused conductive structures. In addition, in addition to the first wiring layer 131 and the second wiring layer 141, the first conductive pad 101 may further include a third wiring layer, a fourth wiring layer, a fifth wiring layer, or the like. In addition, the first wiring layer 131 and the second wiring layer 141 may be integrally formed, that is, except for implementing different functions, the first wiring layer 131 and the second wiring layer 141 have the same film layer structure and material. In FIG. 5, the first wiring layer 131 and the second wiring layer 141 are drawn in the same filling manner.

In some embodiments, still referring to FIG. 13, in the horizontal direction Y, the first wiring layer 131 and the second wiring layer 141 may further have an isolation layer 151 therebetween. For example, the first dielectric layer 122 has an isolation layer 151, which helps improve an insulation effect between the first wiring layer 131 and the second wiring layer 141 through the isolation layer 151.

In some embodiments, the isolation layer 151 may be an air gap.

In some embodiments, referring to FIG. 14, the first conductive pad 101 may include a barrier layer 161 and a conductive layer 171. In the vertical direction X, the conductive layer 171 has opposite first and second sides, and the barrier layer 161 covers at least the first and second sides. It may be understood that the barrier layer 161 is configured to prevent conductive ions in the conductive layer 171 from diffusing and migrating to the sub-filling layer 102, so as to avoid a decrease in conductive performance of the conductive layer 171 due to diffusion and migration of the conductive ions, and avoid a decrease in insulation performance of the sub-filling layer 102 due to migration-in of the conductive ions, thereby ensuring relatively high conductivity of the conductive layer 171 and relatively high insulation performance of the sub-filling layer 102.

It should be noted that, with reference to FIG. 13 and FIG. 14, both the first wiring layer 131 and the second wiring layer 141 may include a barrier layer 161 and a conductive layer 171. Hereinafter, the semiconductor structure shown in FIG. 14 is utilized as an example for description of subsequent steps. In actual application, the first conductive pad 101 may alternatively include only the conductive layer 171.

In some embodiments, the material of the barrier layer 161 is at least one of titanium or titanium nitride, and the material of the conductive layer 171 is aluminum. In this way, the barrier layer 161 helps prevent electromigration of aluminum ions.

With reference to FIG. 14 and FIG. 15, graphical processing is performed on the sub-filling layer 102 to form a first opening 112, and the first opening 112 exposes a portion of the surface of the first conductive pad 101.

In some embodiments, referring to FIG. 14, on the basis that the sub-filling layer 102 includes the first dielectric layer 122 and the second dielectric layer 132 that are stacked in the vertical direction X, after the first opening 112 is formed, the first opening 112 is surrounded by the remaining first dielectric layer 122 and the remaining second dielectric layer 132. It may be understood that in the step of performing graphical processing on the sub-filling layer 102, graphical processing is performed on both the first dielectric layer 122 and the second dielectric layer 132.

In some embodiments, referring to FIG. 15, a portion of the surface exposed by the first conductive pad 101 has damage 107.

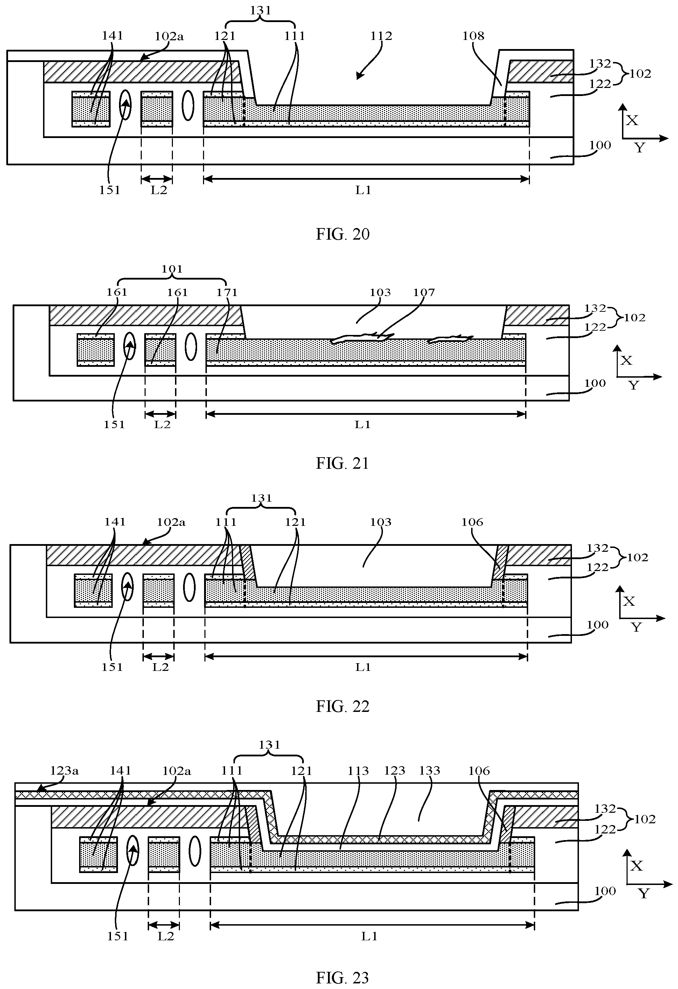

In some embodiments, the damage 107 on the surface of the first conductive pad 101 includes etching damage and probe contact damage. The etching damage may be etching damage caused by an etching process to the surface of the first conductive pad 101 when graphical processing is performed on the first dielectric layer 122 to form the first opening 112. The probe contact damage is etched at a probe mark left by physical contact between a test probe and the first conductive pad 101 is performed when the exposed first conductive pad 101 is configured to test the semiconductor structure after the first opening 112 exposes the surface of the first conductive pad 101. The probe mark damages the surface of the first conductive pad 101, for example, the surface of the first conductive pad 101 is raised. It may be understood that, regardless of etching damage or probe contact damage, the damage 107 affects electrical contact performance between the first conductive interconnection structure 103 subsequently formed in the first opening 112 (referring to FIG. 21) and the first conductive pad 101.

It should be noted that, in FIG. 15, for example, the quantity of the damage 107 on the first conductive pad 101 is 2. In actual application, the quantity of the damage 107 on the first conductive pad 101 is determined according to an actual situation, which is not limited in another embodiment of the present disclosure. In addition, the shape of the damage 107 in FIG. 15 is only an example, and is not limited in an embodiment of the present disclosure.

In some embodiments, still referring to FIG. 15, on the basis that the first conductive pad 101 includes the barrier layer 161 and the conductive layer 171, in the step of performing graphical processing on the sub-filling layer 102 to form the first opening 112, the first opening 112 is further etched to expose one barrier layer 161, that is, the first opening 112 exposes the barrier layer 161, so that a subsequently formed first conductive interconnection structure 103 is directly in contact with and connected to the conductive layer 171.

In some embodiments, referring to FIG. 15 to FIG. 22, the filling layer 142 may further include a fourth dielectric layer 106. The fourth dielectric layer 106 is formed after the first opening 112 is formed and before the first conductive interconnection structure 103 is formed, so that the fourth dielectric layer 106 is located between the first conductive interconnection structure 103 and both of the first dielectric layer 122 and the second dielectric layer 132.

The following describes in detail the step of forming the fourth dielectric layer 106.

Referring to FIG. 15 to FIG. 22, after the first opening 112 is formed, and before the first conductive interconnection structure 103 is formed, the manufacturing method may further include the following steps: The fourth dielectric layer 106 is formed, and at least a portion of the damage 107 on the first conductive pad 101 is removed, where the fourth dielectric layer 106 is located on the sidewall of the first opening 112.

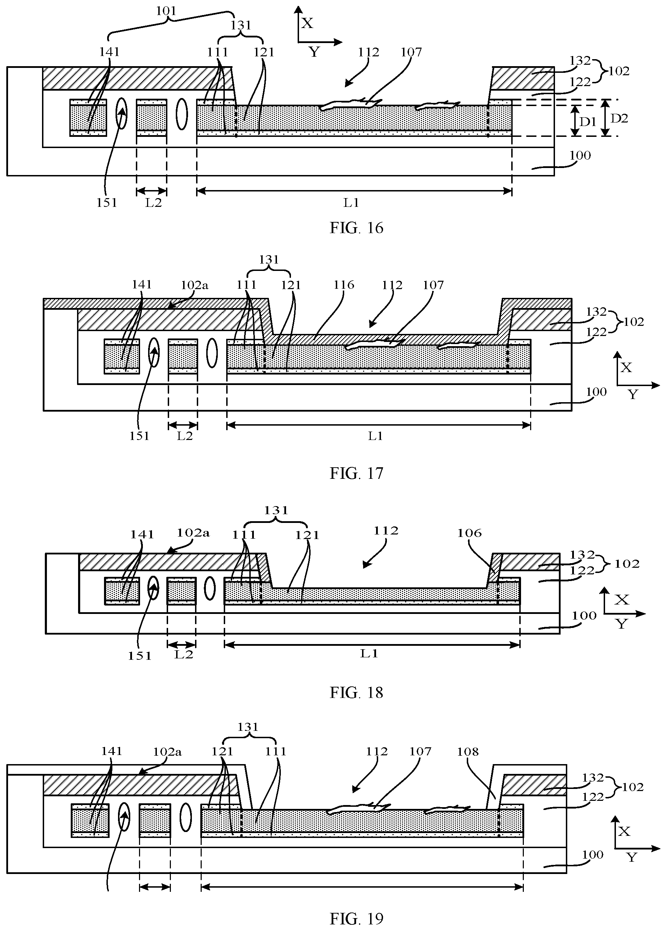

It should be noted that, in FIG. 18, for example, the damage 107 on the first conductive pad 101 is removed. In actual application, because of a limitation on an etching process or another requirement, a small quantity of the damage 107 on the first conductive pad 101 may be retained.

Forming the fourth dielectric layer 106 and removing at least a portion of the damage 107 on the first conductive pad 101 includes at least the following two embodiments.

In some embodiments, referring to FIG. 16, a first opening 112 exposes a portion of the top surface of a first conductive pad 101, the thickness of the first conductive pad 101 whose top surface is exposed by the first opening 112 is a first thickness D1, the thickness of a first conductive pad 101 whose top surface is not exposed by the first opening 112 is a second thickness D2, and the first thickness D1 is less than the second thickness D2.

It may be understood that the first conductive pad 101 whose top surface is exposed by the first opening 112 is a second portion 121, and the first thickness D1 is the thickness of the second portion 121; and the first conductive pad 101 whose top surface is not exposed by the first opening 112 is a first portion 111, and the second thickness D2 is the thickness of the first portion 111. Because the second portion 121 of a partial thickness is also etched in the step of forming the first opening 112, the first thickness D1 is less than the second thickness D2, so that the top surface 100a of the first substrate 100 is utilized as a reference, and the top surface 121a of the second portion 121 is lower than the top surface 111a of the first portion 111.

In some other embodiments, for example, the semiconductor structure shown in FIG. 5 is formed, and the same first opening 112 exposes top surfaces of multiple first conductive pads 101. In this way, orthographic projections of at least two first conductive pads 101 on the first substrate 100 overlap an orthographic projection of one first conductive interconnection structure 103 subsequent formed in one first opening 112 on the first substrate 100, so that the first conductive pad 101 and the first conductive interconnection structure 103 are in a multiple-to-one relationship.

In some embodiments, the steps of forming the fourth dielectric layer 106 and removing at least a portion of the damage 107 on the first conductive pad 101 may include: forming an initial fourth dielectric layer 116 with reference to FIG. 16 and FIG. 17, where the initial fourth dielectric layer 116 conformally covers the surface of the first opening 112 and the top surface 102a of the sub-filling layer 102. It may be understood that the initial fourth dielectric layer 116 may cover the damage 107, and the top surface 102a of the sub-filling layer 102 is the top surface 132a of the second dielectric layer 132 (referring to FIG. 2).

It should be noted that when the first conductive pad 101 includes the first wiring layer 131 and the second wiring layer 141, the exposed wiring layer is the first wiring layer 131.

With reference to FIG. 17 and FIG. 18, the initial fourth dielectric layer 116 is etched back to remove the initial fourth dielectric layer 116 located on the top surface 102a of the sub-filling layer 102 and the bottom surface of the first opening 112, and the remaining initial fourth dielectric layer 116 is the fourth dielectric layer 106. In the step of etching back the initial fourth dielectric layer 116, a partial thickness of the first conductive pad 101 exposed by the first opening 112 is further etched in the vertical direction X. In other words, a partial thickness of the first conductive pad 101 exposed by the first opening 112 is etched away.

It may be understood that in the step of etching back the initial fourth dielectric layer 116 to form the fourth dielectric layer 106, when the etching process removes the initial fourth dielectric layer 116 located on the bottom surface of the first opening 112, the damage 107 covered by the initial fourth dielectric layer 116 is also removed, that is, the second portion 121 is etched, so as to remove at least a portion of the damage 107, and at the same time, and the fourth dielectric layer 106 located on the sidewall of the first opening 112 is configured to avoid etching of the sub-filling layer 102 constituting the sidewall of the first opening 112. In addition, the steps of forming the fourth dielectric layer 106 and removing at least a portion of the damage 107 may be performed synchronously. In this way, in the step of etching the damage 107, the fourth dielectric layer 106 is configured to protect the sidewall of the first opening 112, so as to avoid etching of the first dielectric layer 122 constituting the sidewall of the first opening 112, so that the sidewall of the first opening 112 has a relatively flat interface, and subsequently, a first conductive interconnection structure 103 with a flat size is formed. In addition, in the step of etching the damage 107, a possible pollutant on the surface of the first conductive pad 101 may be further removed through an etching process, which helps further reduce a contact resistance between the subsequently formed first conductive interconnection structure 103 and the first conductive pad 101.

In actual application, the thickness of the etched second portion 121 is adjusted according to adjustment of an etching process parameter, so as to ensure that the damage 107 is completely removed.

In some embodiments, still referring to FIG. 18, in the step of etching the initial fourth dielectric layer 116 to form the fourth dielectric layer 106 on the basis of the conductive layer 171 exposed by the first opening 112, the etching process may further etch a partial thickness of the conductive layer 171, that is, etch a partial thickness of the second portion 121, in the vertical direction X. In actual application, the first opening may expose one barrier layer. In the step of etching back the initial fourth dielectric layer to form the fourth dielectric layer, the etching process removes at least one barrier layer exposed by the first opening, so that a subsequently formed first conductive interconnection structure is directly contact with and connected to the conductive layer.

It should be noted that in FIG. 16 to FIG. 18, a first portion 111 and a second portion 121 are divided with a thick dashed line, and division of the first portion 111 and the second portion 121 in the first conductive pad 101 depends on the area of the first conductive pad 101 exposed by the first opening 112.

In some other embodiments, referring to FIG. 16, a first conductive pad 101 whose top surface is exposed by the first opening 112 is the second portion 121, a first conductive pad 101 whose top surface is not exposed by the first opening 112 is the first portion 111, and the exposed surface of the second portion 121 has damage 107. The steps of forming the fourth dielectric layer 106 and removing at least a portion of the damage 107 on the first conductive pad 101 may include: forming a mask layer 108 with reference to FIG. 16 and FIG. 19, where the mask layer 108 is located on the sidewall of the first opening 112 and the top surface 102a of the sub-filling layer 102, and the mask layer 108 exposes a portion of the top surface of the first conductive pad 101 exposed by the remaining first opening 112, that is, a portion of the top surface of the second portion 121.

With reference to FIG. 19 and FIG. 20, the damage 107 is etched with the mask layer 108 as a mask to etch a partial thickness of the first conductive pad 101 exposed by the first opening 112 in the vertical direction X. In this way, it is advantageous to protect the sub-filling layer 102 through the mask layer 108 in the step of etching the damage 107.

With reference to FIG. 20 and FIG. 18, the mask layer 108 is removed and the fourth dielectric layer 106 is formed.

It should be noted that the manufacturing method provided in another embodiment of the present disclosure sets no limitation on a method for forming the fourth dielectric layer 106 after the mask layer 108 is removed. In some embodiments, the step of forming the fourth dielectric layer 106 may include: first forming a protective film conformally covering the first opening after the mask layer is removed and the second top surface of the first dielectric layer, and then etching back the protective film to form the fourth dielectric layer 106.

It may be understood that, after the damage 107 is removed, the fourth dielectric layer 106 is formed, so as to avoid that a protective film utilized for the next fourth dielectric layer 106 is exposed to an etching environment for too long, thereby improving film layer uniformity of the formed fourth dielectric layer 106, and improving a blocking effect of the fourth dielectric layer 106 on diffusion and migration of conductive ions in the subsequently formed first conductive interconnection structure 103.

S103: A first conductive interconnection structure 103 filling the first opening 112 is formed. In some embodiments, with reference to FIG. 15 and FIG. 21, the fourth dielectric layer is not formed on the sidewall of the sub-filling layer 102, and the first conductive interconnection structure 103 is directly formed in the first opening 112. In actual application, if the first conductive pad 101 has damage 107, the first conductive interconnection structure 103 covers the damage 107.

In some other embodiments, with reference to FIG. 18 and FIG. 22, the step of filling the first opening 112 with the first conductive interconnection structure 103 on the basis of forming the fourth dielectric layer 106, that is, removing the damage 107 (referring to FIG. 16) includes: filling the remaining portion of the first opening 112 with the first conductive interconnection structure 103. It may be understood that the fourth dielectric layer 106 and the first conductive interconnection structure 103 jointly fill the first opening 112.

It should be noted that forming the first conductive interconnection structure 103 and the second conductive pad 105 is subsequently described in detail through the semiconductor structure shown in FIG. 18.

In some embodiments, with reference to FIG. 18 and FIG. 23, the step of forming the first conductive interconnection structure 103 may include: forming a first diffusion barrier layer 113, where the first diffusion barrier layer 113 conformally covers the inner wall of the first opening 112 and the top surface 102a of the sub-filling layer 102; forming a first seed layer 123, where the first seed layer 123 conformally covers the surface of the first diffusion barrier layer 113; and forming a first plating layer 133, where the first plating layer 133 fills the remaining portion of the first opening 112 and is located on the top surface 123a of the first seed layer 123 far away from the sub-filling layer 102.

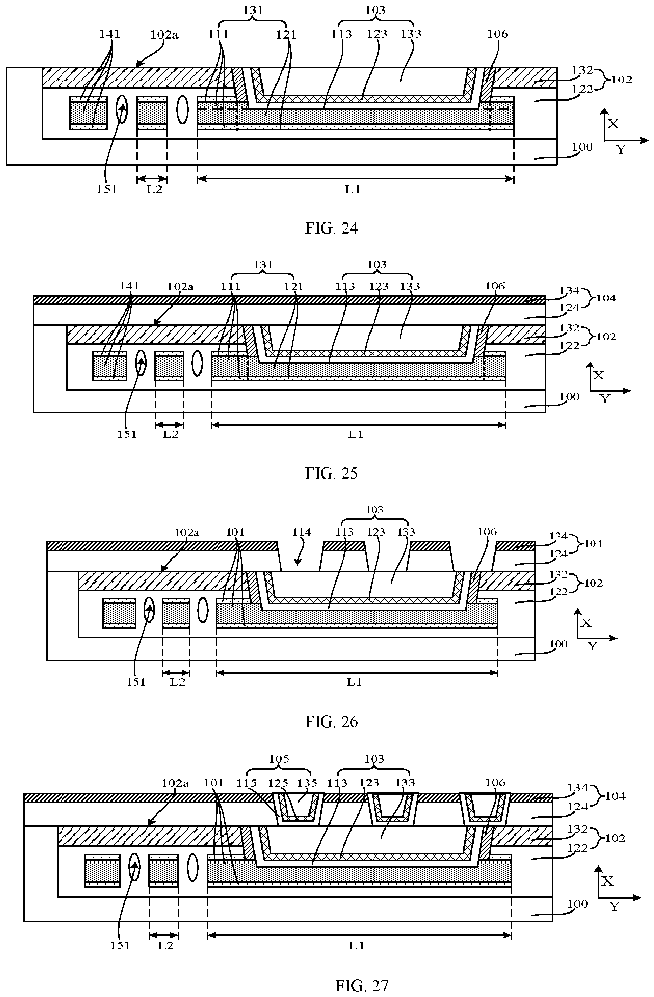

With reference to FIG. 23 and FIG. 24, flattening processing is performed on the first diffusion barrier layer 113, the first seed layer 123, and the first plating layer 133 until the top surface 102a of the sub-filling layer 102 is exposed, and the remaining first diffusion barrier layer 113, the remaining first seed layer 123, and the remaining first plating layer 133 constitute the first conductive interconnection structure 103.

It may be understood that the first plating layer 133 is formed based on the first seed layer 123 through a plating process, which helps improve conductivity of the first plating layer 133, so as to further improve overall conductivity of the first conductive interconnection structure 103. In addition, the first diffusion barrier layer 113 is configured to prevent conductive ions in the first seed layer 123 and the first plating layer 133 from diffusing and migrating to the sub-filling layer 102, so as to avoid a decrease in conductive performance of the first seed layer 123 and the first plating layer 133 due to diffusion and migration of the conductive ions, and a decrease in insulation performance of the sub-filling layer 102 due to migration-in of the conductive ions. That is, it is ensured that the conductive performance of the first seed layer 123 and the first plating layer 133 is relatively high and the insulation performance of the sub-filling layer 102 is relatively high.

In some embodiments, the material of the first diffusion barrier layer 113 is at least one of tantalum or tantalum nitride, and the material of the first seed layer 123 and the first plating layer 133 is copper. In this way, the first diffusion barrier layer 113 helps prevent electromigration of copper ions.

In some embodiments, after the first conductive interconnection structure 103 is formed in the first opening 112, flattening processing is performed on the surface of the first conductive interconnection structure 103, so that a first predetermined height difference H1 exists between the top surface 132a of the second dielectric layer 132 and the top surface 103a of the first conductive interconnection structure 103 with reference to FIG. 2, where the range of the first predetermined height difference H1 is 0 nm to 50 nm.

In some embodiments, referring to FIG. 24 to FIG. 27, S104: multiple second conductive pads 105 are formed on the first conductive interconnection structure 103, so that at least one of the first conductive pads 101 and at least one of the second conductive pads 105 are electrically connected through the first conductive interconnection structure 103.

In some embodiments, referring to FIG. 24 to FIG. 27, after the first conductive interconnection structure 103 is formed, the dielectric layer 104 is formed, and the second conductive pad 105 electrically connected to the first conductive interconnection structure 103 is formed in the third dielectric layer 104.

In some embodiments, referring to FIG. 27, the step of forming the second conductive pad 105 may include: forming at least two second conductive pads 105 in contact with and connected to the top surface 103a of the first conductive interconnection structure 103 away from the first conductive pad 101. It may be understood that one first conductive interconnection structure 103 is in contact with and connected to at least two second conductive pads 105, which helps improve transmission efficiency of an electrical signal among the first conductive pad 101, the first conductive interconnection structure 103, and the second conductive pad 105.

It should be noted that, in FIG. 27, for example, one first conductive interconnection structure 103 is connected to three second conductive pads 105. In actual application, a quantity of second conductive pads 105 in contact with and connected to the same first conductive interconnection structure 103 may be determined according to an actual requirement, for example, the quantity may be one, two, four, or five.

In some embodiments, forming at least two second conductive pads 105 may include the following steps:
Referring to FIG. 25, a dielectric layer 104 is formed on the top surface jointly formed by the sub-filling layer 102 and the first conductive interconnection structure 103.

In some embodiments, still referring to FIG. 25, the third dielectric layer 124 and the first bonding layer 134 are stacked on the second dielectric layer 132, and the third dielectric layer 124 and the first bonding layer 134 constitute the dielectric layer 104. It may be understood that the third dielectric layer 124 and the first bonding layer 134 jointly implement electrical insulation between the second conductive pad 105 subsequently formed in the dielectric layer 104 and another conductive structure in the semiconductor structure.

In some embodiments, the material of the third dielectric layer 124 is silicon oxide, and the material of the first bonding layer 134 is silicon nitride. In this way, when silicon oxide is utilized to improve electrical insulation performance between the second conductive pad 105 subsequently formed in the third dielectric layer 124 and another conductive structure in the semiconductor structure, silicon nitride is utilized to improve hardness of the dielectric layer 104, that is, improve mechanical stability of the entire structure.

With reference to FIG. 25 and FIG. 26, graphical processing is performed on the dielectric layer 104 to form multiple second openings 114 spaced apart from each other. At least two second openings 114 expose different regions of the top surface 103a of the same first conductive interconnection structure 103, and other second openings 114 expose the top surface 102a of the sub-filling layer 102 of the filling layer 142.

It may be understood that a first conductive interconnection structure 103 in contact with and connected to the second conductive pad 105 is formed in the sub-filling layer 102. Only the second opening 114 needs to be formed in the dielectric layer 104, and the second conductive pad 105 filling the second opening 114 is subsequently formed. In this way, the depth of the second opening 114 utilized to form the second conductive pad 105 is only related to the thickness of the dielectric layer 104. Even if the width of the second opening 114 in the horizontal direction Y is less than the width of the first conductive interconnection structure 103 in the horizontal direction Y, the depth-to-width ratio of the second opening 114 is not very large. It is not easy to leave an etching by-product at the contact between the first conductive interconnection structure 103 and the second conductive pad 105. The etching by-product herein mainly comes from the step of performing graphical processing on the dielectric layer 104.

With reference to FIG. 26 and FIG. 27, a second diffusion barrier layer 115 is formed, and the second diffusion barrier layer 115 conformally covers the inner wall of the second opening 114. A second seed layer 125 is formed, where the second seed layer 125 conformally covers the surface of the second diffusion barrier layer 115. A second plating layer 135 is formed, the second plating layer 135 fills the remaining portion of the second opening 114, and the second diffusion barrier layer 115, the second seed layer 125, and the second plating layer 135 form the second conductive pad 105.

It may be understood that the second plating layer 135 is formed based on the second seed layer 125 through a plating process, which helps improve conductivity of the second plating layer 135, so as to further improve overall conductivity of the second conductive pad 105. In addition, the second diffusion barrier layer 115 is configured to prevent conductive ions in the second seed layer 125 and the second plating layer 135 from diffusing and migrating to the dielectric layer 104, so as to avoid a decrease in conductive performance of the second seed layer 125 and the second plating layer 135 due to diffusion and migration of the conductive ions, and a decrease in insulation performance of the dielectric layer 104 due to migration-in of the conductive ions. That is, it is ensured that conductivity of the second seed layer 125 and the second plating layer 135 is relatively high, and insulation performance of the dielectric layer 104 is relatively high.

In some embodiments, the material of the second diffusion barrier layer 115 is at least one of tantalum or tantalum nitride, and the material of the second seed layer 125 and the second plating layer 135 is copper. In this way, the second diffusion barrier layer 115 helps prevent electromigration of copper ions.

It should be noted that in FIG. 27, the first diffusion barrier layer 113 and the second diffusion barrier layer 115 are drawn in the same filling manner. In actual application, materials of the first diffusion barrier layer 113 and the second diffusion barrier layer 115 may be the same or different.

In some embodiments, referring to FIG. 8, the filling layer may further include a first bonding layer 134, the second conductive pad 105 has a top surface exposed on the first bonding layer 134, a second predetermined height difference H2 exists between the top surface of the second conductive pad 105 exposed on the first bonding layer 134 and the top surface of the first bonding layer 134, and the range of the second predetermined height difference H2 is 0 nm to 50 nm. After the second conductive pad 105 is formed, the manufacturing method may further include: forming a second bonding layer 234 directly bonded to the first bonding layer 134 and a third conductive pad 205 directly bonded to the second conductive pad 105.

It should be noted that the step of forming the third conductive pad 205 is similar to the step of forming the second conductive pad 105, and details are not described herein again.

In conclusion, after the first opening 112 exposing the first conductive pad 101 is formed, the first conductive interconnection structure 103 is formed in the first opening 112, so as to omit the step of forming an isolation layer filling the first opening 112 and forming a via for forming a conductive pillar in the isolation layer, thereby simplifying a process step of preparing a semiconductor structure. In addition, the first conductive interconnection structure 103 is formed in the first opening 112. On one hand, it helps to increase the contact area between the first conductive interconnection structure 103 and the first conductive pad 101, so as to reduce a contact resistance between the first conductive interconnection structure 103 and the first conductive pad 101. On the other hand, the first conductive interconnection structure 103 in contact with and connected to the first conductive pad 101 does not need to be formed in a deep hole etching manner, that is, to avoid generating an etching by-product not easy to remove, so as to avoid existence of an etching by-product between the first conductive pad 101 and the first conductive interconnection structure 103 or in the first conductive interconnection structure 103, thereby helping improve conductivity of the first conductive interconnection structure 103, reducing a contact resistance between the first conductive interconnection structure 103 and the first conductive pad 101, and avoiding poor contact between the first conductive interconnection structure 103 and the first conductive pad 101, so as to improve electrical performance of the semiconductor structure.

A person of ordinary skill in the art may understand that the foregoing implementations are specific embodiments for implementing the present disclosure. In an actual application, various modifications may be made to the forms and details of the implementations without departing from the spirit and scope of the embodiments of the present disclosure. Any person skilled in the art may make changes and modifications without departing from the spirit and scope of the embodiments of the present disclosure. Therefore, the protection scope of the embodiments of the present disclosure shall be subject to the scope defined by the claims.

## Claims

1. A semiconductor structure, comprising:
a first substrate (100) and a semiconductor device located in the first substrate (100);
a plurality of first conductive pads (101), connected to the semiconductor device;
a plurality of second conductive pads (105), at least one of the first conductive pads (101) and at least one of the second conductive pads (105) being electrically connected through a first conductive interconnection structure (103) extending in a direction perpendicular to the first substrate (100); and
a filling layer (142), the filling layer (142) being filled in an outer periphery of each of the first conductive pads (101), the first conductive interconnection structure (103), and each of the second conductive pads (105), wherein the first conductive interconnection structure (103) has a surface (103b) buried by the filling layer (142) between adjacent second conductive pads (105).

2. The semiconductor structure according to claim 1, wherein the filling layer comprises a first dielectric layer, a second dielectric layer, and a third dielectric layer, the first dielectric layer covers the first conductive pad, the third dielectric layer covers a sidewall of the second conductive pad, the second dielectric layer is located between the first dielectric layer and the third dielectric layer, a first predetermined height difference exists between a top surface of the second dielectric layer and a top surface of the first conductive interconnection structure, and a range of the first predetermined height difference is 0 nm to 50 nm.

3. The semiconductor structure according to claim 2, wherein the first dielectric layer and the second dielectric layer constitute a sub-filling layer; and the filling layer further comprises a fourth dielectric layer, and the fourth dielectric layer is located between the sub-filling layer and the first conductive interconnection structure.

4. The semiconductor structure according to claim 2, wherein at least one of the second conductive pads is located on the top surface of the second dielectric layer.

5. The semiconductor structure according to claim 4, wherein the second conductive pad located on the top surface of the second dielectric layer is not electrically connected to the first conductive pad, and the second conductive pad is in direct contact with the top surface of the second dielectric layer.

6. The semiconductor structure according to claim 1, wherein the first conductive pad in electrical contact with the first conductive interconnection structure comprises a first portion and a second portion, the second portion is in direct contact with the first conductive interconnection structure, the first portion is not in direct contact with the first conductive interconnection structure, and a surface of the second portion in direct contact with the first conductive interconnection structure has a portion lower than a surface of the first portion.

7. The semiconductor structure according to claim 1, wherein orthographic projections of at least two of the first conductive pads on the first substrate overlap an orthographic projection of one first conductive interconnection structure on the first substrate.

8. The semiconductor structure according to claim 1, wherein the filling layer comprises a first bonding layer, the second conductive pad has a top surface exposed on the first bonding layer, a second predetermined height difference exists between the top surface of the second conductive pad exposed on the first bonding layer and a top surface of the first bonding layer, and a range of the second predetermined height difference is 0 nm to 50 nm.

9. The semiconductor structure according to claim 8, further comprising a second bonding layer and a third conductive pad located in the second bonding layer, wherein the second bonding layer is directly bonded to the first bonding layer, and the third conductive pad is directly bonded to the second conductive pad.

10. The semiconductor structure according to claim 1, further comprising an isolation layer, the isolation layer being located in the filling layer between adjacent first conductive pads.

11. A manufacturing method for a semiconductor structure, comprising:
providing a first substrate, the first substrate having a semiconductor device;
forming a plurality of first conductive pads connected to the semiconductor device;
forming a first opening, the first opening exposing a surface of at least one of the first conductive pads;
forming a first conductive interconnection structure filling the first opening; and
forming a plurality of second conductive pads on the first conductive interconnection structure, so that at least one of the first conductive pads and at least one of the second conductive pads are electrically connected through the first conductive interconnection structure;
wherein a filling layer is formed on an outer periphery of each of the first conductive pads, each of the second conductive pads, and the first conductive interconnection structure, and the first conductive interconnection structure has a surface buried by a filling layer between adjacent second conductive pads.

12. The manufacturing method according to claim 11, wherein the filling layer comprises a first dielectric layer, a second dielectric layer, and a third dielectric layer, the first conductive pad is formed in the first dielectric layer, the second dielectric layer is formed above the first dielectric layer, the first dielectric layer and the second dielectric layer are formed before the first opening is formed, and the first opening is formed in the first dielectric layer and the second dielectric layer;
after the first conductive interconnection structure is formed in the first opening, flattening processing is performed on a surface of the first conductive interconnection structure, so that a first predetermined height difference exists between a top surface of the second dielectric layer and a top surface of the first conductive interconnection structure, wherein a range of the first predetermined height difference is 0 nm to 50 nm; and
after the first conductive interconnection structure is formed, the third dielectric layer is formed, and the second conductive pad electrically connected to the first conductive interconnection structure is formed in the third dielectric layer.

13. The manufacturing method according to claim 12, wherein the filling layer further comprises a fourth dielectric layer, the fourth dielectric layer is formed after the first opening is formed and before the first conductive interconnection structure is formed, so that the fourth dielectric layer is located between the first conductive interconnection structure and both of the first dielectric layer and the second dielectric layer.

14. The manufacturing method according to claim 13, wherein the step of forming the fourth dielectric layer comprises: forming an initial fourth dielectric layer, the initial fourth dielectric layer conformally covering a surface of the first opening and the top surface of the second dielectric layer; and etching back the initial fourth dielectric layer to remove the initial fourth dielectric layer located on the top surface of the second dielectric layer and a bottom surface of the first opening, the remaining initial fourth dielectric layer being the fourth dielectric layer, wherein in the step of etching back the initial fourth dielectric layer, a partial thickness of the first conductive pad exposed by the first opening is etched away.

15. The manufacturing method according to claim 11, wherein the filling layer further comprises a first bonding layer, the second conductive pad has a top surface exposed on the first bonding layer, a second predetermined height difference exists between the top surface of the second conductive pad exposed on the first bonding layer and a top surface of the first bonding layer, and a range of the second predetermined height difference is 0 nm to 50 nm; and after the forming the second conductive pad, the method further comprises: forming a second bonding layer directly bonded to the first bonding layer and a third conductive pad directly bonded to the second conductive pad.
